## Europäisches Patentamt
## European Patent Office
## Office européen des brevets

(19)

(11) Veröffentlichungsnummer: **0 188 474**
**B1**

(12)

# EUROPÄISCHE PATENTSCHRIFT

(45) Veröffentlichungstag der Patentschrift:
**18.10.89**

(51) Int. Cl.⁴: **H 04 N 5/76**

(21) Anmeldenummer: **85903258.3**

(22) Anmeldetag: **25.06.85**

(86) Internationale Anmeldenummer:
**PCT/EP 85/00306**

(87) Internationale Veröffentlichungsnummer:
**WO 86/00771 (30.01.86 Gazette 86/3)**

(54) AUDIO/VIDEO-ADAPTER FÜR AUDIO-VISUELLE GERÄTE.

(30) Priorität: **06.07.84 DE 3424931**

(43) Veröffentlichungstag der Anmeldung:
**30.07.86 Patentblatt 86/31**

(45) Bekanntmachung des Hinweises auf die Patenterteilung:
**18.10.89 Patentblatt 89/42**

(84) Benannte Vertragsstaaten:
**AT BE CH DE FR GB IT LI LU NL SE**

(56) Entgegenhaltungen:
EP-A- 0 094 896
DE-A- 3 140 814
US-A- 3 483 548
US-A- 4 276 562

IEEE Transactions on Broadcoast and Television Receivers", vol. BTR-18, no. 2, May 1972, New York (US), M. Koubek: "The probable impact of video recorders and videoplayers on circuit cesign of TV receivers", pp. 98-103
Grundig Technische Informationen, no. 3, 1969 Furth (DE), "Der Bild-Ton-Adapter 900 zum Anschluss des Video-Recorders BK100 an Fernsehempfänger", pp. 397-400
Grundig Technische Informaticnen, no. 4, 1976, Fürth(DE), VZ71 und AZ71, zwei Bausteine zur Einkopplung von Video- und Audiosignalen in Farbfernsehgeräte ohne Netztrennung", pp. 782-785

(73) Patentinhaber: **Deutsche Thomson-Brandt GmbH, Hermann-Schwer-Strasse 3 Postfach 1307, D-7730 Villingen-Schwenningen (DE)**

(72) Erfinder: **KRÄMER, Lothar, Graneggstrasse 13, D-7732 Niedereschach (DE)**

**Beschreibung**

Die Erfindung betrifft einen Audio/Video-Adapter gemäss dem Oberbegriff des ersten Anspruchs.

Es sind audio-visuelle Geräte der Unterhaltungselektronik bekannt, die unterschiedliche Viedeo-/Audioanschlussbuchsen aufweisen. Wenn AV-Geräte, die unterschiedliche Anschlussbuchsen nach DIN 45 582 (alt) resp. DIN EN 50 049 (Europa-Norm) besitzen, miteinander arbeiten sollen, treten Probleme auf. Als AV-Geräte kommen beispielsweise in Frage: Bildplattenspieler, Mixer, Video-Regie-Geräte, Fernsehgeräte, Monitore und Videorecorder.

Mit den bisherigen Verbindungskabeln war es nur möglich Verbindungen in jeweils einer Richtung herzustellen. Das heisst genauer erklärt, es war entweder nur eine Verbindung z.B. zwischen einem Fernsehgerät mit DIN-Buchse und einem Videorecorder mit Europa-Normbuchse (SCART) mittels eines Kabels der Type I oder eine Verbindung zwischen einem Fernsehgerät mit Europa-Normbuchse (SCART) und einem Videorecorder mit DIN-Buchse mittels eines Kabels der Type II möglich. Da die Europa-Normbuchse (SCART) getrennte Ein- und Ausgänge für Video- und Audio-Signale (letztere für «Rechts» und «Links» bzw. Zweikanalton) hat, die «alte» DIN-Buchse aber jeweils einen gemeinsamen Ein- bzw. Ausgang besitzt, musste der Signalweg je nach Signalrichtung umgeschaltet werden. Diese Umschaltung wurde über einen Signalwegvorwahlschalter mit einem Relais durchgeführt.

Aus der DE-A1-31 40 814 wurde eine Lösung universeller Art bekannt, der die Aufgabe zu grunde lag, die zusätzliche Bedienung wie Umstecken von Verbindungsleitungen oder das Betätigen eines Vorwahlschalters zu vermeiden, wenn AV-Geräte mit von einander abweichenden Anschlussbuchsen miteinander betrieben werden sollen. Die hier beanspruchte und beschriebene elektronische Erkennungsschaltung soll angeblich in der Lage sein, aus dem Vorhandensein und der Art der zugeführten Audio- oder Videosignale zu erkennen, ob die angeschlossenen AV-Geräte diese Signale ausgeben oder aufnehmen und dementsprechend dann einen Schaltbefehl an die Umschalteinrichtung abgeben, die die Ausgangsleitungen der ausgebenden Audio/Videogeräte mit den Eingangsleitungen der aufnehmenden Audio/Videogeräte automatisch richtig verbindet.

Diese Lösung ist mit den gegenwärtig zur Verfügung stehenden Mitteln nicht zu einem marktgängigen Preis realisierbar.

Der Erfindung lag somit die Aufgabe zu grunde, einen Audio/Video-Adapter so auszustatten, dass mit nur einem Adapter in beiden Richtungen gearbeitet werden kann und zwar zwischen zwei unterschiedlichen AV-Geräten, aber auch mit zwei Videorecordern bei Überspielungen, wenn die zusammenarbeitenden Geräte Anschlussbuchsen unterschiedlicher Norm aufweisen. Diese Aufgabe wird für den angegebenen Gattungsbegriff des ersten Anspruchs erfindungsgemäss nach seinem Kennzeichen gelöst.

Weitere Einzelheiten sind dem abhängigem Anspruch sowie der Beschreibung eines Ausführungsbeispiels zu entnehmen.

Ein erfindungsgemässer Adapter erlaubt es vorteilhafterweise, Überspielungen zwischen zwei Videorecordern in beiden Richtungen beliebig vorzunehmen und zwar unabhängig von der Position des Vorwahlschalters.

Nachfolgend wird die Erfindung an hand der Zeichnung beschrieben. Diese zeigt in

Figur 1 ein vereinfachtes Blockschaltbild des Adapters;

Figur 2 eine beispielhafte Ausführung des Adapters, wobei der Vorwahlschalter, die Logik und die von ihr angesteuerte Umschalteinheit in einem Gehäuse untergebracht sind;

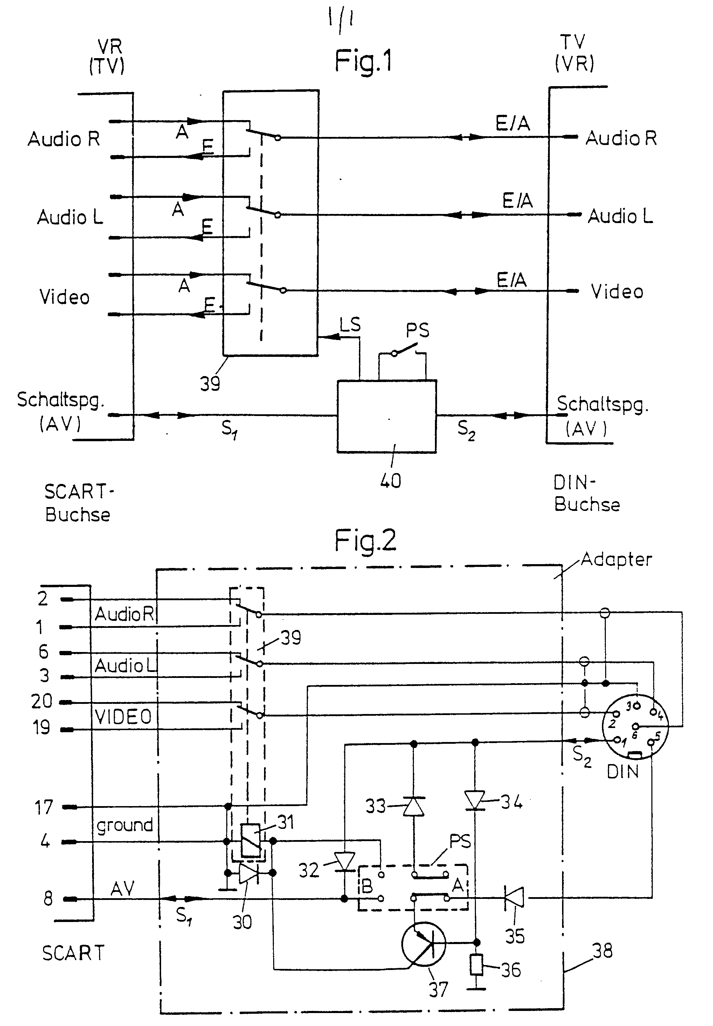

In Figur 1 sind miteinander zu verbindenden AV-Geräte, Videorecorder (VR) mit Fernsehempfänger (TV) links und rechts angedeutet. Sie haben unterschiedliche Anschlussbuchsen, links eine Euro-Normbuchse (SCART-Buchse) und rechts eine DIN-Buchse. Die SCART-Buchse besitzt separate Kontakte für Eingänge und Ausgänge bei Audio R, Audio L und Video. Das ist bei der DIN-Buchse nicht der Fall. Durch Pfeile und «E»- bzw. «A»-Bezeichnung sind die Signalrichtungen für Eingänge und Ausgänge angedeutet. Eine Logik 40 ist zwischen den jeweiligen Schaltspannungsanschlüssen der Buchsen angeschlossen, die bei Schliessen des Schalters PS, der der Vorwahl der Signalrichtung dient, aktiviert wird und dadurch über den mit LS bezeichneten Ausgang eine Umschalteinrichtung- oder einheit 39 derart ansteuert, dass alle drei Schalter von den Ausgangs- auf die Eingangsanschlüsse geschaltet werden. So ist dann vom rechten AV-Gerät mit der DIN-Buchse eine Wiedergabe auf dem linken AV-Gerät möglich, beispielsweise die Wiedergabe von einem Videorecorder auf einem Fernsehgerät. Die Logik 40 verbindet selbsttätig bei einem Wiedergabevorgang von einem Videorecorder die nur dann anstehende AV-Schaltspannung $S_2$ mit dem entsprechenden Kontakt des anderen AV-Gerätes über $S_1$, gleichzeitig wird diese Spannung zur Speisung der Logik und der Umschalteinrichtung verwendet.

Figur 2 zeigt ein detailliertes Ausführungsbeispiel eines Adapters. Die mit der Figur 1 übereinstimmenden oder entsprechenden Positionen erhielten die gleiche Bezeichnung. Die SCART- und die DIN-Buchse sind mit allen Kontakten und ihren Nummernbezeichnungen eingezeichnet. Die Umschalteinheit 39 wird von einem Relais 31 betätigt, das in Stellung B des Vorwahlschalters PS über den Transistor 37 aktiviert wird. Die elektronische Schaltlogik 40 enthält die Dioden 30, 32, 33, 34, 35 und einen Widerstand 36 für die Basisvorspannung des Transistors 37. Die Diode 34 liegt im Basiskreis, die Diode 32 im Emitterkreis bei Stellung B des Vorwahlschalters PS, hingegen im Stellung A die Diode 35.

Wie in Figur 2 mit dem strich-punktierten Gehäuse 38 angedeutet, kann der Adapter in diesem Gehäuse ausgeführt werden und umfasst so Logik 40, Vorwahlschalter PS und Umschalteinrichtung 39 auf praktische Weise.

**Patentansprüche**

1. Audio/Video-Adapter für die gegenseitige Verbindung zur Zusammenarbeit zweier AV-Geräte für Aufnahme bzw. Wiedergabe-Betrieb, wobei diese beiden Geräte AV-Anschlussbuchsen unterschiedlicher Norm haben und einen Schalter für die Signalrichtungswahl sowie eine in Abhängigkeit davon gesteuerte Umschalteinrichtung aufweisen, die ein Gerät mit getrennten Buchsenkontakten für Ein- und Ausgänge der beiden Audiosignale und des Videosignals mit einem Gerät mit gemeinsamen Ein- und Ausgangsleitungen entsprechend der Quelle- oder Senkefunktion der Geräte aufschaltet, dadurch gekennzeichnet, dass eine elektronische Logikschaltung (40) vorgesehen ist und auf grund ihrer Verknüpfung mit dem Schalter (PS) für die Signalrichtungswahl und der Umschalteinrichtung (39) so ausgebildet ist, dass bei

A. Aufnahme durch einen mit einer beliebigen der beiden AV-Anschlussbuchsen ausgestatteten Videorecorder die Signalwege für (L und R) und Video in der Grundstellung (A) des Schalters (PS) entsprechend durchgeschaltet sind;

B. Wiedergabe von einem die eine AV-Buchsenart aufweisenden Videorecorder auf einem die andere AV-Buchsenart besitzenden AV-Empfangs-Gerät die am Videorecorder dann anstehende Schaltspannung mittels der Logikschaltung (40) von der Umschaltstellung (B) des Schalters (PS) angesteuert sowohl die Umschalteinrichtung aktiviert, die die erforderlichen Kontakte für die Audio- (L und R) und den Videosignalweg verbindet, als auch die Schaltspannung an das empfangende AV-Gerät weiterleitet und hierbei diese Schaltspannung zur Speisung von Logikschaltung (40) und gegebenenfalls Umschalteinrichtung (39) mitbenutzt.

2. Audio/Video-Adapter gemäss Anspruch 1, dadurch gekennzeichnet, dass der Vorwahlschalter (PS) für die Signalwege als zweipoliger Umschalter ausgebildet ist, der in seiner Grundstellung (A) die Wiedergabe von einem AV-Gerät mit DIN-Anschlussbuchse (DIN) an ein aufnehmendes AV-Gerät mit Euro-Norm-Anschlussbuchse (SCART) durchschaltet und der in seiner Schaltstellung (B) die Wiedergabe von einem AV-Gerät mit Euro-Norm-Anschlussbuchse (SCART) an ein aufnehmendes AV-Gerät mit DIN-Anschlussbuchse (DIN) verbindet, wobei die Umschalteinrichtung (39) über die Logikschaltung (40) bestehend aus einem Transistor (37) und je einer Diode im Basis- (34) und Emitterkreis (32) aktiviert wird, indem der Transistor (37) in dieser Schalterstellung (B) durchgeschaltet wird.

**Revendications**

1. Adaptateur audio/vidéo destiné à relier réciproquement, pour leur coopération, deux appareils audiovisuels pour un fonctionnement de réception ou de lecture, ces deux appareils possédant des prises de raccordement audio/vidéo correspondant à des normes différentes et contenant un commutateur pour la sélection de la direction de transmission des signaux ainsi qu'un dispositif de commutation, qui est commandé en fonction de cette sélection et raccorde un appareil comportant des contacts séparés de prise pour des entrées et des sorties des deux signaux audio et du signal vidéo, à un appareil comportant des conducteurs communs d'entrée et de sortie, conformément à la fonction d'émission ou de la fonction de réception des appareils, caractérisé en ce qu'il est prévu un circuit logique électronique (40), qui est agencé, sur la base de sa combinaison avec le commutateur (PS) utilisé pour la sélection de la direction de transmission des signaux, et avec le dispositif de commutation (39), de telle sorte que

A. lors de la réception réalisée par un enregistreur vidéo quelconque, équipé des deux prises de raccordement audio/vidéo, les voies de transmission de signaux pour (L et R) et vidéo sont interconnectées de façon correspondante, lorsque le commutateur (PS) est dans la position de base (A);

B. lors de la lecture depuis un enregistreur vidéo, comportant un type de prise audio/vidéo, en direction d'un appareil de réception audiovisuel possédant l'autre type de prise audio/vidéo, la tension de commutation apparaissant alors dans l'enregistreur vidéo est commandée au moyen du circuit logique 40, par la position de commutation (B) du commutateur (PS) et active le dispositif de commutation, qui relie les contacts nécessaires pour la voie de transmission de signaux audio (L et R) et la voie de transmission de signaux vidéo et retransmet latension de commutation à l'appareil audiovisuel récepteur et utilise conjointement cette tension de commutation pour alimenter le circuit logique (40) et éventuellement le dispositif de commutation (39).

2. Adaptateur audio/vidéo selon la revendication 1, caractérisé en ce que le commutateur de présélection (PS) pour les voies de transmission de signaux est réalisé sous la forme d'un commutateur bipolaire, qui, dans sa position de base (A), réalise la lecture depuis un appareil audiovisuel comportant une prise de raccordement DIN (DIN) à un appareil audiovisuel récepteur, comportant une prise de raccordement correspondant à la norme européen (SCART) et qui, dans sa position de commutation (B), réalise la lecture depuis un appareil audio/vidéo comportant une prise de raccordement correspondant à la norme européen (SCART) à un appareil audiovisuel récepteur comportant une prise de raccordement DIN (DIN), le dispositif de commutation (39) étant activé par l'intermédiaire du circuit logique (40) constitué par un transistor (37) et des diodes montées respectivement dans le circuit de base (34) et dans le circuit d'émetteur (32), le transistor (37) étant placé à l'état conducteur lorsque le commutateur est dans cette position (B).

**Claims**

1. Audio/video adapter for the mutual connection of two cooperating AV apparatuses for recording or playback mode, these two apparatuses having AV connection sockets conforming to different standards and comprising a switch for signal direction selection and a switching device controlled in dependence thereon which connects an apparatus with separate socket contacts for inputs and putputs of the two audio signals and the video signal with an apparatus with common input and output leads according to the source or sink function of the apparatuses, characterised in that an electronic logic circuit (40) is provided which by virtue of its connection to the switch (PS) for signal direction selection and of the switching device (39) is so designed that in the case of

A. recording by a video recorder equipped with any one of the two AV connection sockets, the signal paths for (L and R) and video are correspondingly connected through with the switch (PS) in the normal position (A);

B. playback by a video recorder comprising one kind of AV socket on an AV receiving apparatus possessing the other kind of AV socket, the switching voltage then applied to the video recorder and controlled by means of the logic circuit (40) by the switching position (B) of the switch (PS) both activates the switching device connecting the requisite contacts for the audio- (L and R) and video signal paths and also passes on the switching voltage to the receiving AV apparatus and in so doing exploits this switching voltage to feed the logic circuit (40) and in certain cases the switching device (39).

2. Audio-video adapter according to Claim 1, characterised in that the pre-selector switch (PS) for the signal paths is designed as a two-pole switch which in its normal position (A) switches through the playback from an AV apparatus with DIN connection socket (DIN) to a recording AV apparatus with Euro-standard connection socket (SCART) and which in its switching position (B) connectes the playback from an AV apparatus with Euro-standard connection socket (SCART) to a recording AV apparatus with DIN connection socket (DIN), the switching device (39) being activated via the logic circuit (40), consisting of a transistor (37) and a diode in both the base (34) and the emitter circuit (32), by the transistor (37) being turned on in this switch position (8).

# Fig.1

VR
(TV)

TV
(VR)

Audio R    A
           E                    E/A         Audio R

Audio L    A
           E                    E/A         Audio L

Video      A
           E                    E/A         Video

                    LS        PS

                    39

Schaltspg.                              Schaltspg.
(AV)              S₁        S₂              (AV)

                    40

SCART-                                  DIN-
Buchse                                  Buchse

# Fig.2

Adapter

SCART

2
    AudioR
1
                    39
6
    AudioL
3
20
    VIDEO
19

17
    ground
4                   31
            32          PS
8   AV                          A
    S₁      30          B       35
                                37   36
                                            38

33      34

S₂

DIN